(19) Europäisches Patentamt
European Patent Office
Office européen des brevets

(11) **EP 2 001 127 B1**

(12) **EUROPEAN PATENT SPECIFICATION**

(45) Date of publication and mention
of the grant of the patent:
**11.01.2012 Bulletin 2012/02**

(51) Int Cl.:
*H03F 1/32* *(2006.01)*     *H04B 1/04* *(2006.01)*

(21) Application number: **07011316.2**

(22) Date of filing: **08.06.2007**

(54) **System and method for linearizing microwave transmitters**

System und Verfahren zur Linearisierung von Mikrowellensender

Système et procédé pour la linéarisation de transmetteurs à micro-ondes

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**10.12.2008 Bulletin 2008/50**

(73) Proprietor: **SIAE Microelettronica S.p.A.**
**20093 Cologno Monzese (MI) (IT)**

(72) Inventors:
• **Rossi, Leonardo**
**29100 Piacenza (IT)**

• **Biscevic, Goran**
**20091 Bresso**
**(MI) (IT)**
• **Salvaneschi, Cesare**
**27043 Broni**
**(PV) (IT)**

(74) Representative: **Gatti, Enrico et al**
**Gianbrocono & C. s.p.a.**
**Via E. Zambianchi, 3**
**24121 Bergamo (IT)**

(56) References cited:
EP-A- 1 705 801        US-A1- 2001 005 402
US-A1- 2005 157 814    US-A1- 2007 129 025

**Description**

The present invention relates to a system and method for linearizing microwave transmitters. More particularly it relates to a system and method for determining predistortion coefficients for microwave transmitters.

The production of microwave transmitters for radio link systems encounters a power limit given by the non-linearity of the microwave circuits, with the result that the power which these should be able to provide cannot be properly utilized. Particularly in the case of a large number of modulation levels and a high peak power/average power ratio, the power providable by microwave transmitters is necessarily under-utilized.

Many studies and circuits exist in the literature and on the market for counteracting the non-linearity effect by various methods. One of the most effective or appreciated methods is the adaptive method: this has the conceptual advantage of adapting to the particular conditions of each individual device by an automatic linearizing system able to follow the time variations in the transmitter characteristics arising from the climatic utilization conditions, particularly temperature, as in those devices positioned externally in the direct vicinity of the antenna and hence subjected to all atmospheric variations.

However only certain equipment structures enable an adaptive system to be used, whereas others are strongly hindered because of particularly high working frequencies and constructional requirements which do not enable the adaptive feedback circuit to be formed with an acceptable compromise between cost and result.

The adaptive method has the main advantage of automatically identifying the feedback necessary for linearizing the device without the complicating requirement of having to know the non-linearity characteristic of the block, which would otherwise have to be obtained by laborious and costly methods in terms of measurement time. In this respect, each physical block produced normally requires individual linearizing treatment.

The method viewed with greatest interest by constructors is that which enables signal predistortion to be achieved just as the signal is created within the digital process. In this manner the action to be taken is merely represented by an addition of calculations and operations to the number already existing in the digital formation of the signal containing the information to be transmitted: an increase in these is viewed more favourably than a system using a circuit specifically added for that function.

The document EP 1 705 801 discloses a distortion compensation apparatus which includes a memory storing distortion compensation coefficients in designated write addresses, and outputting a distortion compensation coefficient stored in a designated readout address; a predistortion section performing distortion compensation processing of a transmission signal, using the distortion compensation coefficient being output from the memory; and a distortion compensation section calculating an update value of a distortion compensation coefficient, based on an error component existing between the transmission signal before distortion compensation processing and the transmission signal after it has been amplified by an amplifier. Further, the distortion compensation section modifies the magnitude of the step size parameter, thus determining the degree of effect of the error component produced on the update value, when calculating the update value of the distortion compensation coefficient.

The document US 2005/0157814 discloses a digital predistorter comprising an input for receiving a digital communication signal comprising a stream of signal samples. A linear dynamic compensation circuit is coupled to the input and provides a linear operation on a plurality of time delayed signal samples. A digital envelope detector is also coupled to the input and provides a stream of discrete digital envelope signal samples corresponding to the input signal samples. A first nonlinear dynamic compensation circuit is coupled to the envelope detector and provides a nonlinear operation on a plurality of delayed envelope signal samples. A second nonlinear dynamics compensation circuit is coupled in a cascade arrangement with the first nonlinear dynamic compensation circuit and provides an autoregressive operation on plural samples of the output of the first nonlinear dynamic compensation circuit. A combiner combines the outputs of the linear dynamics compensation circuit and the second nonlinear dynamics compensation circuit and provides a digital predistortion signal as an output.

An object of the present invention is to provide an easily implemented system and method for linearizing microwave transmitters.

Another object is to provide a system which enables predistortion coefficients to be obtained easily and in reduced number.

These and further objects are attained according to the present invention by a system for determining predistortion coefficients for microwave transmitters according to claim 1.

The said objects are also attained by a method for determining predistortion coefficients for microwave transmitters according to claim 6.

Further characteristics of the invention are described in the dependent claims.

The characteristics and advantages of the present invention will be apparent from the ensuing detailed description of one embodiment thereof illustrated by way of non-limiting example in the accompanying drawings, in which:

Figure 1 shows schematically the power transfer function of a non-linear device, in accordance with the present invention;
Figure 2 shows schematically a system for linearizing microwave transmitters, in accordance with the present invention.

Let i(mt) and q(mt) be two sample sequences obtained from information transmitted at discrete moments m of time t with a suitable degree of over-sampling. This latter will be at least double the maximum frequency which it is required to control.

Two sinusoidal carriers in quadrature $cos\omega_o(t)$ and $sin\omega_o(t)$ are then amplitude modulated, these being abbreviated hereinafter as $cos\omega_o$, $sin\omega_o$, $i$, $q$, the time t being implied.

Again with time implied, the modulated signal

$$S = i\ cos\omega_o - q\ sin\omega_o$$

is produced, this being sent to the input of the non-linear block, to produce an output containing distortions theoretically of all orders, of the type:

$$g(s) = \gamma_1\ s + \gamma_2\ s^2 + \gamma_3\ s^3 + \gamma_4\ s^4 + \gamma_5\ s^5 + ...$$

in which the coefficients $\gamma_i$ are transfer functions of the non-linear block which produces the terms at the various $i^{th}$ powers ($\gamma_1$ is assumed to be 1). These coefficients are a function of the physical characteristics of the device; moreover it is known that the even order terms can be ignored as they are intrinsically localized at higher frequencies excluded from the baseband by normal filters. The remaining terms of interest are only the odd terms containing components which fall within the baseband and as far as a certain extension outside it. The components falling within the baseband cause degradation of the signal/noise ratio while the outside components cause undesirable widening of the transmitted spectrum which can disturb adjacent channels. The odd order terms hence have to be limited.

The designer must thus evaluate the maximum order level to which the counter-measures have to be operated, based on the targeted performance.

The calculations are then made, being limited here to the fifth order as an example, but taking care to exclude those terms containing angular functions of $cos3\omega_o$ or higher: each signal power is multiplied by its own coefficient

$$\gamma_n = \alpha_n + j^* \beta_n$$

The signal obtained is then demodulated by again multiplying by

$$cos\omega_o - sin\omega_o$$

to obtain the useful terms in demodulated baseband with the following components:

$$Re(dem) = i + \tfrac{3}{4}\ \alpha_3(i^3 + iq^2) - \tfrac{3}{4}\ \beta_3(q^3 + qi^2) + \tfrac{3}{4}\ \alpha_5(i^5 +$$

$$2i^3q^2 + iq^4) - \tfrac{3}{4}\ \beta_5(q^5 + 2q^3i^2 + qi^4)$$

$$Im(dem) = q + \tfrac{3}{4}\ \alpha_3(q^3 + qi^2) + \tfrac{3}{4}\ \beta_3(i^3 + iq^2) + \tfrac{3}{4}\ \alpha_5(q^5 +$$

$$2q^3i^2 + qi^4) + \tfrac{3}{4}\ \beta_5(i^5 + 2i^3q^2 + iq^4)$$

These are the two demodulated baseband signal components which contain the non-linearity effects.

This invention provides pseudoadaptivity of the method to minimize the non-linear terms

$$\tfrac{3}{4}\,\alpha_3 i^3 + \tfrac{3}{4}\,\alpha_3 i q^2 - \tfrac{3}{4}\,\beta_5 q^3 \ldots \text{ etc.}$$

which appear in reception. Of these, the most inner parts $i^3$, $iq^2$, $q^3$ ...etc. generally define non-linear functions NLF(i, q).

The method consists of avoiding the characterization of the non-linear block with the traditional measurements necessary for the purpose which are laborious and costly even if automatable, by instead implementing an automatic adaptive system able to linearize the block by automatic predistortion of the input signal. The predistortion is effected by a non-linear transversal equalizer positioned before the non-linear block within the digital baseband process needed to generate the modulating signal. Sach equalizer is reduced to a single delay cell equivalent to a single multidimensional coefficient. This implementation, which does not require a figure, is summarized in the following calculations.

The samples i and q of the sequence to be transmitted are corrected by the predistortion as follows

$$i' = i + \Sigma_k\,NLF_k(i,q)\,cre_k$$

$$q' = q + \Sigma_k\,NLF_k(i,q)\,cim_k$$

In the described example the index k extends from 1 to 10, 10 being the exemplified NLFs (Non Linear Functions) which are used to equalize i and q and their arguments. In this application the signals i and q are taken at the same sampling time.

In other words, referring to known techniques, the structure of a transversal filter with a single multidimensional coefficient is being implemented. A linear adaptive equalizer makes use of four dimension coefficients (4D in equalizer wording), in this case being the equalizer non-linear the number of dimensions is well larger than four.

The problem now consists of determining the coefficients cre and cim.

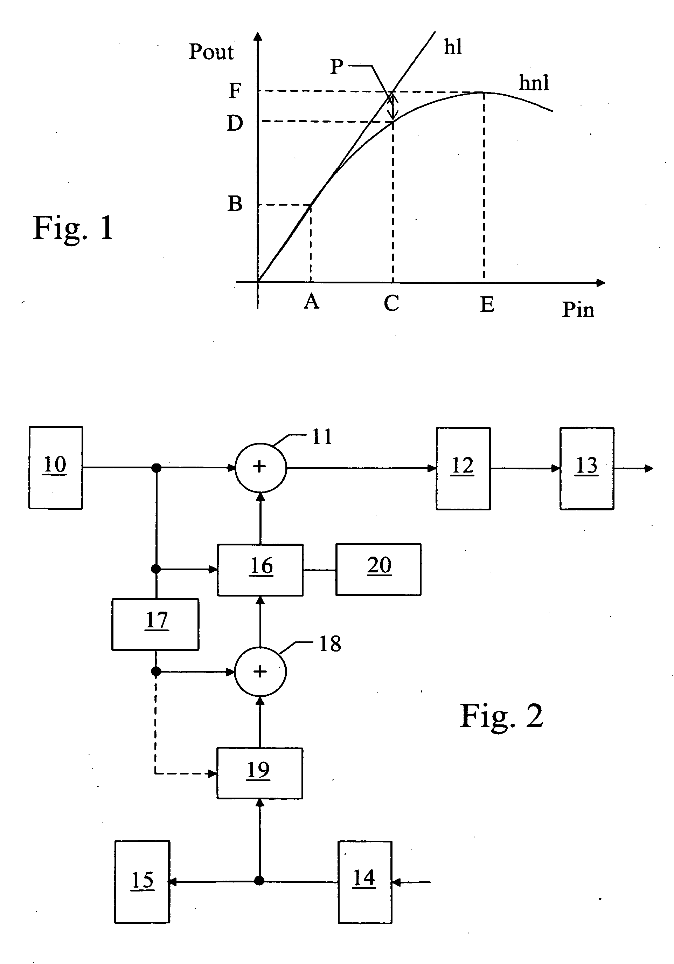

With reference to Figure 1 in which the horizontal axis represents the level Pin of the power entering a non-linear device and the vertical axis represents the level Pout of the output signal, a linear transfer function hl is shown, together with a hypothetical non-linear transfer function hnl and the predistortion correction to be applied to the input signal in order to obtain an output level linearly dependent from the input level.

Let consider a signal entering the non-linear amplification block at the indicated mean power level A. The device then produces a corresponding mean output power level B given by the slope of the transfer curve hnl which for that value is still quite linear.

In particular cases, which are not all that rare, the input power can have a peak C as shown: the device responds with an effective output level D which is well below the required level F, with a loss of P. To counteract the phenomenon, the input power of that peak must be increased to the value E to provide the correct output power.

If the non-linear phase transfer function were to be shown, the considerations would be totally similar.

A practical counteracting technique would be to determine and memorize the input signal within the entire input power/output power plane in order to establish the extent of the increment for each input value. The problem arises that this would have to be done for each non-linear device produced, with which the individual amplitude (AM-AM) and phase (AM-PM) maps would have to be associated with adequate resolution. In the current state of the art, manufacturers consider that such a choice is not convenient or too costly because of the large amount of data which would have to accompany the use of each non-linear block manufactured.

In contrast, in this invention, the method is used of identifying said mainly responsible NLFs and of determining the corrective coefficients for each of them: the cost becomes that of memorizing only a certain number of coefficients in a single situation of mean power level of the transmitted signal, instead of an otherwise much more extensive mapping.

Each NLF contributes to determining the total loss, and for each of them there is a corresponding corrective increment value for re-establishing the level. The increment and correction segments are necessarily different, as the phenomenon is non-linear, and individually variable as a function of the peak value.

The previously given formula, which consists of a multidimensional equalization, finds various solutions in the literature.

For example the article by Lottici, Luise, Reggiannini et al. suggest to apply the feedback methods typical of adaptive equalization. In this respect, those circuits are seen within the overall context of a linear and non-linear equalization in which the coefficients are updated on the basis of a given error by the method of minimization of the mean square error (MMSE), for correcting the coefficient k at the time "ii+1".

The following formula summarizes the process:

$$crek_{ii+1} = crek_{ii} - stsz(e_{ii+1} \ NLF_k)$$

$$cimk_{ii+1} = cimk_{ii} - stsz(e_{ii+1} \ NLF_k)$$

in which *stsz* is a compression factor ($<<10^{-7}$). The term within parentheses is proportional to the correlation between the error "e" at the time ii+1 and the NLF controlled by said coefficient and containing the i and q terms at the time ii+1; k varies from 1 to 10 as in the preceding example.

Other articles (Levy, Karam, Sari) suggest methods for slowing the coefficient updating rate.

Benedetto, Biglieri, Castellani in "Digital Transmission Theory" suggest analysing the channel to firsly reduce the number of NLFs to the necessary minimum in order to choose those which produce the most important effects, and then applying the MMSE criterion.

In this invention a choice is made regarding the manner of applying the method which is centered on calculating the error "e" with which to control the coefficient correction.

According to the present invention, the objective of controlling the transmitted spectrum regrowing along with the added noise within the baseband, can be achieved only if the coefficient updating rate is the same as the transmission oversampling rate.

The problem to be solved is therefore the method to calculate the error "e", which becomes the fundamental point.

The chosen solution to calculate the error "e" is based on the transmitteddata and not on the decided data as is commonly done in the MMSE case.

Hence the error "e" is determined by the difference between the baseband signal which is to be transmitted (suitably delayed) and the signal received and demodulated (in baseband).

In this manner the control of the signal components at their related frequencies is complete and suitable to the case of linearizing a non-linear device in the absence of memory, i.e. without filtering.

The problem is solved by providing the following steps:

a) acquiring the coefficients in adaptive mode with a suitable circuit during the production/testing of the non-linear block;

b) memorizing the acquired coefficients and using them in normal operation without any further adaptation;

c) using a suitable method, described hereinafter, to measure the characteristic coefficients of the non-linear block at a single operating condition (operating point at a given output power), and extending their use, in a simple manner, to different operating points such as when, for example, the power to be transmitted has to be varied: if it is decreased the extent of the predistortion must consequently be reduced.

Point c) relates to the fact that the non-linear block must be used under various different conditions related both to the variability of power to be transmitted, and to the variation of the peak/mean power ratio. These variations must be maintained satisfied by the single acquired measurement characterizing the non-linear block. At the discretion of the designer several measurements can be made if it is considered necessary to acquire different non-linear block characteristics due, for example, to variations in temperature or in other environmental conditions.

The predistortion circuit consists of a block which executes the aforestated predistortion operation: the coefficients are extracted from a memory relative to the non-linear block in use and applied in accordance with the linearization formula, calculating the new predistorted modulating signals i' and q' from the original i and q signals.

The modulating signals i' and q' corrected in this manner are then fed to the modulator to form the spectrum to be transmitted.

The adaptive updating of the coefficients for their acquisition, at the preceding point a), involves a system which has to be implemented only during the production step, and which is described in the following block scheme.

With reference to Figure 2, a system for linearizing microwave transmitters, according to the present invention, comprises a generator 10 for signals obtained from the data to be transmitted (the modulating signal), which is connected to an input port of a first adder node 11, the output of the adder node 11 being connected to a modulator 12 connected to a transmitter 13.

A receiver 14 receives the signal transmitted by the transmitter 13. The output of the receiver 14 is connected to a block 15 which implements the receive equalizer function, recovers the carrier and locks the system synchronization clock.

The signals generated by the generator 10 are also fed to a predistorter 16, the output of which is connected to the second input port of the adder 11. These signals are also fed to a delay block 17, the output of which is connected to a second adder 18 and possibly to a sampling and synchronisation block 19.

The output of the receiver 14 is also connected to the sampling and synchronisation block 19.

The predistorter 16 is connected to a memory 20 for storing the calculated predistortion coefficients.

The scheme is non-limitative, any other which attains its objects being considered equivalent.

This circuit is to be set up during the testing stage for each non-linear device.

It operates in the following manner. The generator 10 generates the modulating signals in accordance with system requirements, including shaping filtering.

The adder 11 adds to the modulating signals i and q the predistortion generated by the predistorter 16, in accordance with the preceding formula.

The output signal from the adder node enters the modulator 12, the modulated carrier being transmitted by the non-linear block (transmitter 13) at the required maximum power for the device, and for which the required distortion conditions are to be satisfied.

At the same time the signals are delayed by the delay block 17 and fed to the adder 18 and if necessary also to the block 19 to facilitate signal synchronization.

The signal is returned to baseband by a receiver 14, demodulator, sampling and synchronisation block 19 in cascade.

It is preferable not to insert filters into the demodulation chain. If it were so, the linearizing capacity would be reduced with direct influence on spectrum regrowing control. A wide band system as described can normally be prepared on a production bench.

The demodulated signal is sampled at the same rate as the transmitted one.

The block 19 synchronizes the delayed signals coming from the delay block 17 with the signals received by the receiver 14.

The modulating samples are suitably delayed in order to be compared with their sampled version in reception.

The adder 18 effects the difference between the signals at its input ports to provide an output indicative of the error between said two signals.

The calculated difference error between the original and the received signals is used to apdate the coefficients.

When steady conditions are reached the stabilized coefficients are stored in the memory 20.

Optional use of the linear equalizer block 15 is suggested for recovering the synchronisms which are usefull for coherent demodulation of the signal transmitted by the transmitter 13.

The coefficients are acquired, as already described, for the most severe peak/mean power ratio at which the non-linear block is operated.

This linearization must still be suitable for all the modulation orders and/or rolloff values.

With further reference to Figure 1, the maximum output power level on the curve hnl corresponds to the maximum allowable input level E on the horizontal axis : this is a physical limit which cannot be exceeded.

Hence the coefficients acquired in the described manner are automatically characterized by the fact that the predistortion peak does not exceed this maximum.

The mean input and output power levels are correspondingly lower on the basis of the characteristic

PP/MP ratio of the signal.

The problem which now arises is that it may be required to modify the mean power level to be transmitted in the sense of reducing it, the previous operating point being relative to maximum power: this reduction requires the extent of the predistortion to be reduced. Alternatively the signal at the input of the non-linear block can be varied, with a different but lower PP/MP ratio, having for example to vary the modulation order (reduced number of levels) and/or the rolloff value.

The designer knowing the differences between the previous maximum conditions and the other less severe conditions is able to adequately transfer the mean input power point.

In this respect, the predistortion bloch + non-linear block system has now been made linear, as previously described.

Hence if a reduction by X dB of output power from the transmitter (i.e. from the non-linear block) is required, the corresponding predistortion reduction is obtained by reducing the input power level to the predistortion block by X dB.

Alternatively, the use of a new modulated signal (lower modulation order) characterized by a PP/MP ratio lower by X dB than the original characterization enables the same linearized distortion condition to be achieved, also increasing by X dB the output power from the transmitter. The new required degree of predistortion can be obtained by increasing the input power to the predistortion block by X dB: the designer should keep in mind that the peaks of the new signal must respect the aforedescribed maximum limit.

If for any circuit or system reasons the power levels at the input to the circuits inserted between the predistortion block and the non non-linear block have to be maintained constant a simple linear variable amplifier can be added at the predistorter output.

In this manner the average power providable by the non-linear block can be utilized to its maximum extent.

A multiplier could be applied before the predistortion block and a multiplier after the predistortion block to multiply the passing through signal with the previously determined coefficients. The log values (dB) of the coefficients vary by the same amount but are applied with opposite signs: if positive before the predistorter they become negative after the predistorter.

The system conceived in this manner is susceptible to numerous modifications and variants, all falling within the scope of the inventive concept.

**Claims**

1. A system for determining the predistortion coefficients for a microwave transmitter comprising: a digital signal source (10) for producing a sampled digital signal; a predistorter (16) which includes a calculation device for distorting said digital signal; and a transmitter (13) transmitting said distorted digital signal; **characterised by** comprising a receiver (14) for receiving said transmitted signal and providing a demodulated sampled signal; a delay device (17) for delaying said sampled digital signal; a comparison device (18) for comparing said delayed sampled digital signal with said demodulated sampled signal to produce a signal indicative of the error between said two sampled signals; a calculation device (16) for determining said predistortion coefficients on the basis of said indicative error signal; and a memory (20) to store said predistortion coefficients; said calculation device (16) using the following formulas:

$$i' = i + \Sigma_k \, NLF_k(i,q) \cdot cre_k$$

$$q' = q + \Sigma_k \, NLF_k(i,q) \cdot cim_k$$

where

$$crek_{ii+1} = crek_{ii} - stsz \cdot e_{ii+1} \cdot NLF_k$$

$$cimk_{ii+1} = cimk_{ii} - stsz \cdot e_{ii+1} \cdot NLF_k$$

in which $stsz$ is a compression factor $<10^{-7}$,
$e_{ii+1}$ is the error between said two signals at the moment $ii+1$,
$NLF_k$ is a non-linear function of index k;
$i$ and $q$ are sampled signals sequences,
$i'$ and $q'$ are sampled signals sequences corrected by the predistortion,
K is the index of the order of the, non-linear functions NLF(i, q), which are used to equalize $i$ and $q$ and their argument.

2. A system as claimed in claim 1, **characterised in that** said digital signal and said demodulated signal are digital signals in baseband.

3. A system as claimed in claim 1, **characterised in that** said predistorter (16) comprises an adder (11) for adding to said digital signal a signal obtained on the basis of said predistortion coefficients.

4. A system as claimed in claim 1 , **characterised in that** said delay device (17) comprises means for synchronizing said digital signal with said demodulated signal.

5. A system as claimed in claim 1, **characterised in that** said transmitter (13) transmits at the maximum power required for the device.

6. A method for determining predistortion coefficients for a microwave transmitters comprising the steps of: generating a digital sampled signal, predistorting said digital signal, then transmitting said distorted digital signal; **characterised**

**by** comprising the steps of receiving said transmitted signal and providing a demodulated sampled signal, delaying said sampled digital signal, comparing said delayed digital signal with said demodulated signal to produce a signal indicative of the error between said two signals, determining said predistortion coefficients on the basis of said indicative error signal during the production/testing of the transmitter, and memorizing said predistortion coefficients; said predistortion coefficients being calculated by means of the following formulas:

$$i' = i + \Sigma_k\ NLF_k(i,q) \cdot cre_k$$

$$q' = q + \Sigma_k\ NLF_k(i,q) \cdot cim_k$$

where

$$crek_{ii+1} = crek_{ii} - stsz \cdot e_{ii+1} \cdot NLF_k$$

$$cimk_{ii+1} = cimk_{ii} - stsz \cdot e_{ii+1} \cdot NLF_k$$

in which $stsz$ is a compression factor $<10^{-7}$,
$e_{ii+1}$ is the error between said two signals at the moment $ii+1$, $NLF_k$ is a non-linear function of index k;
$i$ and $q$ are sampled signals sequences,
$i'$ and $q'$ are sampled signals sequences corrected by the predistortion,
K is the index of the order of the, non-linear functions NLF(i, q), which are used to equalize $i$ and $q$ and their argument.

7. A method as claimed in claim 6, **characterised in that** the predistortion step comprises the step of adding to said digital signal a signal obtained on the basis of said predistortion coefficients.

8. A method as claimed in claim 6, **characterised in that** the delay step comprises the step of synchronizing said digital signal with said demodulated signal.

9. A system for linearizing microwave transmitters during normal service comprising a predistorter which uses the predistortion coefficients determined in accordance with claim 1.

10. A system as claimed in claim 1, **characterised in that** said transmitter transmits at a predetermined power, a variation in said predetermined power giving rise to a corresponding variation in the input power to said predistorter.

**Patentansprüche**

1. System zum Bestimmen der Vorverzerrungskoeffizienten für einen Mikrowellensender, umfassend: eine digitale Signalquelle (10) zum Erzeugen eines abgetasteten digitalen Signals; einen Vorverzerrer (16), der eine Berechnungsvorrichtung beinhaltet, zum Verzerren des digitalen Signals; und einen Sender (13), der das verzerrte digitale Signal sendet; **dadurch gekennzeichnet, dass** es umfasst: einen Empfänger (14) zum Empfangen des gesendeten Signals und zum Liefern eines demodulierten abgetasteten Signals; eine Verzögerungsvorrichtung (17) zum Verzögern des abgetasteten digitalen Signals; eine Vergleichsvorrichtung (18) zum Vergleichen des verzögerten abgetasteten digitalen Signals mit dem demodulierten abgetasteten Signal zum Erzeugen eines Signals, das den Fehler zwischen den beiden abgetasteten Signalen anzeigt; eine Berechnungsvorrichtung (16) zum Bestimmen der Vorverzerrungskoeffizienten auf der Grundlage des den Fehler anzeigenden Signals; und einen Speicher (20) zum Speichern der Vorverzerrungskoeffizienten; wobei die Berechnungsvorrichtung (16) die folgenden Formeln verwendet:

$$i' = i + \sum_k NLF_k(i,q) \cdot cre_k$$

$$q' = q + \sum_k NLF_k(i,q) \cdot cim_k$$

wobei

$$crek_{ii+1} = crek_{ii} - stsz \cdot e_{ii+1} \cdot NLF_k$$

$$cimk_{ii+1} = cimk_{ii} - stsz \cdot e_{ii+1} \cdot NLF_k$$

worin $stsz$ ein Kompressionsfaktor $< 10^{-7}$ ist,
$e_{ii+1}$ der Fehler zwischen den beiden Signalen zum Zeitpunkt $ii+1$ ist,
$NLF_k$ eine nichtlineare Funktion mit Index $k$ ist;
$i$ und $q$ abgetastete Signalsequenzen sind,
$i'$ und $q'$ durch die Vorverzerrung korrigierte abgetastete Signalsequenzen sind, sowie
$K$ der Index der Ordnung der nichtlinearen Funktionen $NLF(i,$
$q)$ ist, die zum Entzerren von i und q und ihres Arguments verwendet werden.

2. System nach Anspruch 1, **dadurch gekennzeichnet, dass** das digitale Signal und das demodulierte Signal digitale Signale im Basisband sind.

3. System nach Anspruch 1, **dadurch gekennzeichnet, dass** der Vorverzerrer (16) einen Addierer (11) zum Addieren eines auf der Grundlage der Vorverzerrungskoeffizienten erhaltenen Signals zu dem digitalen Signal umfasst.

4. System nach Anspruch 1, **dadurch gekennzeichnet, dass** die Verzögerungsvorrichtung (17) ein Mittel zum Synchronisieren des digitalen Signals mit dem demodulierten Signal umfasst.

5. System nach Anspruch 1, **dadurch gekennzeichnet, dass** der Sender (13) mit der für die Vorrichtung benötigten maximalen Leistung sendet.

6. Verfahren zum Bestimmen der Vorverzerrungskoeffizienten für einen Mikrowellensender, umfassend die folgenden Schritte: Erzeugen eines digitalen abgetasteten Signals, Vorverzerren des Signals, dann Senden des verzerrten digitalen Signals; **gekennzeichnet durch** die folgenden Schritte: Empfangen des gesendeten Signals und Liefern eines demodulierten abgetasteten Signals, Verzögern des abgetasteten digitalen Signals, Vergleichen des verzögerten digitalen Signals mit dem demodulierten Signal zum Erzeugen eines Signals, das den Fehler zwischen den beiden Signalen anzeigt, Bestimmen der Vorverzerrungskoeffizienten auf der Grundlage des den Fehler anzeigenden Signals während der Produktion/des Testens des Senders, und Abspeichern der Vorverzerrungskoeffizienten; wobei die Vorverzerrungskoeffizienten mittels der folgenden Formeln berechnet werden:

$$i' = i + \sum_k NLF_k(i,q) \cdot cre_k$$

$$q' = q + \sum_k NLF_k(i,q) \cdot cim_k$$

wobei

$$crek_{ii+1} = crek_{ii} - stsz \cdot e_{ii+1} \cdot NLF_k$$

$$cimk_{ii+1} = cimk_{ii} - stsz \cdot e_{ii+1} \cdot NLF_k$$

worin $stsz$ ein Kompressionsfaktor $< 10^{-7}$ ist,
$e_{ii+1}$ der Fehler zwischen den beiden Signalen zum Zeitpunkt $ii+1$ ist,
$NLF_k$ eine nichtlineare Funktion mit Index $k$ ist;
$i$ und $q$ abgetastete Signalsequenzen sind,
$i'$ und $q'$ **durch** die Vorverzerrung korrigierte abgetastete Signalsequenzen sind, sowie
$K$ der Index der Ordnung der nichtlinearen Funktionen NLF(i,
q) ist, die zum Entzerren von $i$ und $q$ und ihres Arguments verwendet werden.

7. Verfahren nach Anspruch 6, **dadurch gekennzeichnet, dass** der Vorverzerrungsschritt den Schritt des Addierens eines auf der Grundlage der Vorverzerrungskoeffizienten erhaltenen Signals zu dem digitalen Signal umfasst.

8. Verfahren nach Anspruch 6, **dadurch gekennzeichnet, dass** der Verzögerungsschritt den Schritt des Synchronisierens des digitalen Signals mit dem demodulierten Signal umfasst.

9. System zum Liniearisieren von Mikrowellensendern während des normalen Betriebs, umfassend einen Verzerrer, der die gemäß Anspruch 1 bestimmten Vorverzerrungskoeffizienten nutzt.

10. System nach Anspruch 1, **dadurch gekennzeichnet, dass** der Sender mit einer vorbestimmten Leistung sendet, wobei eine Variation in der vorbestimmten Leistung eine entsprechende Variation in der Eingangsleistung des Vorverzerrers verursacht.

**Revendications**

1. Système destiné à déterminer les coefficients de prédistorsion pour un émetteur à micro-ondes comprenant : une source de signal numérique (10) pour produire un signal numérique échantillonné ; un dispositif de prédistorsion (16) qui comprend un dispositif de calcul pour la distorsion dudit signal numérique ; et un émetteur (13) émettant ledit signal numérique distordu ; **caractérisé en ce qu'**il comprend un récepteur (14) pour recevoir ledit signal émis et fournir un signal échantillonné démodulé ; un dispositif de retard (17) pour retarder ledit signal numérique échantillonné ; un dispositif de comparaison (18) pour comparer ledit signal numérique échantillonné retardé au dit signal échantillonné démodulé pour produire un signal indiquant l'erreur entre lesdits deux signaux échantillonnés ; un dispositif de calcul (16) pour déterminer lesdits coefficients de prédistorsion sur la base dudit signal d'indication d'erreur ; et une mémoire (20) pour mémoriser lesdits coefficients de prédistorsion ; ledit dispositif de calcul (16) utilisant les formules suivantes :

$$i' = i + \Sigma_k \, NLF_k(i,q) \cdot cre_k$$

$$q' = q + \Sigma_k \, NLF_k(i,q) \cdot cim_k$$

où

$$crek_{ii+1} = crek_{ii} - stsz \cdot e_{ii+1} \cdot NLF_k$$

$$cimk_{ii+1} = cimk_{ii} - stsz \cdot e_{ii+1} \cdot NLF_k$$

dans lequel stsz est un facteur de compression $< 10^{-7}$,

$e_{ii+1}$ est l'erreur entre lesdits deux signaux au moment ii+1,
$NLF_k$ est une fonction non linéaire d'indice k,
i et q sont des séquences de signaux échantillonnés,
i' et q' sont des séquences de signaux échantillonnés corrigés par la prédistorsion,
K est l'indice de l'ordre des fonctions non linéaires NLF(i, q) qui sont utilisées pour égaliser i et q et leur argument.

2. Système selon la revendication 1, **caractérisé en ce que** ledit signal numérique et ledit signal démodulé sont des signaux numériques en bande de base.

3. Système selon la revendication 1, **caractérisé en ce que** ledit dispositif de prédistorsion (16) comprend un additionneur (11) pour ajouter au dit signal numérique un signal obtenu sur la base desdits coefficients de prédistorsion.

4. Système selon la revendication 1, **caractérisé en ce que** ledit dispositif de retard (17) comprend un moyen pour synchroniser ledit signal numérique avec ledit signal démodulé.

5. Système selon la revendication 1, **caractérisé en ce que** ledit émetteur (13) émet à la puissance maximale requise pour le dispositif.

6. Procédé destiné à déterminer les coefficients de prédistorsion pour un émetteur à micro-ondes comprenant les étapes consistant à : générer un signal échantillonné numérique, opérer une prédistorsion dudit signal numérique, puis transmettre ledit signal numérique distordu ; **caractérisé en ce qu'**il comprend les étapes consistant à recevoir ledit signal transmis et à fournir un signal échantillonné démodulé, à retarder ledit signal numérique échantillonné, à comparer ledit signal numérique retardé au dit signal démodulé pour produire un signal indiquant l'erreur entre lesdits deux signaux, à déterminer lesdits coefficients de prédistorsion sur la base dudit signal d'indication d'erreur au cours de la production/du test de l'émetteur, et à mémoriser lesdits coefficients de prédistorsion ; lesdits coefficients de prédistorsion étant calculés au moyen des formules suivantes :

$$i' = i + \Sigma_k \, NLF_k(i,q) \, . \, cre_k$$

$$q' = q + \Sigma_k \, NLF_k(i,q) \, . \, cim_k$$

où

$$crek_{ii+1} = crek_{ii} - stsz \, . \, e_{ii+1} \, . \, NLF_k$$

$$cimk_{ii+1} = cimk_{ii} - stsz \, . \, e_{ii+1} \, . \, NLF_k$$

dans lequel stsz est un facteur de compression $< 10^{-7}$,
$e_{ii+1}$ est l'erreur entre lesdits deux signaux au moment ii+1, $NLF_k$ est une fonction non linéaire d'indice k,
i et q sont des séquences de signaux échantillonnés,
i' et q' sont des séquences de signaux échantillonnés corrigés par la prédistorsion,
K est l'indice de l'ordre des fonctions non linéaires NLF(i, q) qui sont utilisées pour égaliser i et q et leur argument.

7. Procédé selon la revendication 6, **caractérisé en ce que** l'étape de prédistorsion comprend l'étape consistant à ajouter au dit signal numérique un signal obtenu sur la base desdits coefficients de prédistorsion.

8. Procédé selon la revendication 6, **caractérisé en ce que** l'étape de retard comprend l'étape consistant à synchroniser ledit signal numérique avec ledit signal démodulé.

9. Système pour linéariser des émetteurs à micro-ondes au cours d'un fonctionnement normal comprenant un dispositif de prédistorsion qui utilise les coefficients de prédistorsion déterminés selon la revendication 1.

10. Système selon la revendication 1, **caractérisé en ce que** ledit émetteur émet à une puissance prédéterminée, une variation de ladite puissance prédéterminée engendrant une variation correspondante de la puissance d'entrée sur ledit dispositif de prédistorsion.

Fig. 1

Fig. 2

**EP 2 001 127 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1705801 A